# EUROPEAN PATENT SPECIFICATION

(11) **EP 3 351 364 B1**
(45) Date of publication and mention of the grant of the patent: **21.08.2019**
(21) Application number: 16846506.0
(22) Date of filing: 14.09.2016
(51) Int. Cl.: B29C 59/04, B29C 33/38, H01L 21/027, B29C 41/36, B29C 59/02, B29C 37/00, B29C 35/08

(54) **METHOD FOR MANUFACTURING MOLD FOR IMPRINTING**
VERFAHREN ZUR HERSTELLUNG EINER FORM ZUM PRÄGEN
PROCÉDÉ DE FABRICATION DE MOULE D'ESTAMPAGE

(30) Priority: 17.09.2015 JP 2015184535
(43) Date of publication of application: 25.07.2018
(73) Proprietor: Soken Chemical & Engineering Co., Ltd., Toshima-ku Tokyo 171-8531 (JP)
(72) Inventor: SAKATA, Ikumi, Sayama-shi Saitama 350-1320 (JP); TAKEDA, Ai, Sayama-shi Saitama 350-1320 (JP)
(74) Representative: Gulde & Partner
(86) International application number: PCT/JP2016/077098
(87) International publication number: WO 2017/047635

(56) References cited:
- WO-A1-2013/031460
- WO-A1-2014/080857
- WO-A1-2014/080857
- JP-A- H0 620 308
- JP-A- 2002 524 298
- JP-A- 2003 181 918
- JP-A- 2003 181 918
- US-A1- 2010 203 183

## Description

### TECHNICAL FIELD

The present invention relates to a method for manufacturing an imprint mold.

### BACKGROUND

Imprint technology is a fine processing technology, which uses a mold having a reverse pattern of a desired fine concave-convex pattern. The mold is pressed against a transferring material on a substrate, thereby transferring the reverse pattern of the mold onto the transferring material. Here, the transferring material is a liquid resin for example. The reverse pattern of the fine concave-convex pattern can vary between a nano-scale pattern of 10 nm-level size to a 100µm-level size. The reverse pattern is used in a wide range of field including semiconductor materials, optical materials, recording media, micro machines, biotechnology, and environmental protection.

With respect to a transferring method to transfer the reverse pattern onto the transferring material, an imprint mold in the form of a roll manufactured by winding a film mold onto a transfer roll, or a metal roll manufactured by carving out a metal can be used. These rolls are used in the roll to roll method to continuously transfer the reverse pattern onto the transferring material.

In order to prepare a roll-shape imprint mold from a film mold, it is necessary to join both ends of the film mold. As a method for joining the film mold, Patent Literature 1 discloses a method in which the film mold is wound around a cylinder transfer roll so that a clearance without the reverse pattern of the concave-convex pattern is provided at the portion where the both ends of the film molds are butted. Then, a resin composition is filled in the clearance and a pattern substantially the same as the reverse pattern is formed on the resin composition filled. According to such method, a continuous reverse pattern can be provided over the entire circumference of the transfer roll. In addition, such transfer roll can be used to transfer the reverse pattern to form a continuous concave-convex pattern onto a transferring material.

### CITATION LIST

### PATENT LITERATURE

Patent Literature 1: WO2014/080857

### SUMMARY OF THE INVENTION

### PROBLEMS TO BE SOLVED BY THE INVENTION

However, with the method of Patent Literature 1, level difference tends to occur between the reverse pattern formed on the film mold and the reverse pattern formed on the resin composition in the clearance. The level difference between these reverse patterns would also be transferred onto the concave-convex pattern formed on the transferring material, resulting in transfer defectiveness.

The present invention has been made by taking the aforementioned circumstances into consideration. An object of the present invention is to provide a method for manufacturing an imprint mold which can suppress transfer defectiveness.

### MEANS TO SOLVE THE PROBLEM

According to the present invention, a method for manufacturing an imprint mold, comprising: a winding step to wind a film mold onto a cylinder transfer roll, the film mold having a resin layer, the resin layer having a base pattern comprising a reverse pattern of a fine concave-convex pattern and the film mold being wound so as to form a clearance having no base pattern at a butting portion of both ends of the film mold; a resin filling step to fill a resin composition in the clearance; and a pattern forming step to form an additional pattern comprising a reverse pattern of a transfer pattern on the resin composition by pressing the transfer pattern provided on a pattern adding mold against the resin composition; wherein the resin composition is filled so as to form a protruding portion of the resin composition at a surface of the resin layer by allowing the resin composition to protrude from the clearance before the pattern adding mold is pressed against the resin composition or when the pattern adding mold is pressed against the resin composition, is provided. The protruding portion is removed from the surface of the resin layer by being adhered on the pattern adding mold when the pattern adding mold is removed from the resin composition.

According to the present invention, the resin composition protrudes from the clearance at the portion where the both ends of the film molds are butted so as to form a resin composition protrusion at the surface of the resin layer. Accordingly, occurrence of level difference between the base pattern and the additional pattern can be suppressed.

Hereinafter, various embodiments of the present invention will be exemplified. The embodiments provided hereinafter can be combined with each other.

Preferably, the pattern adding mold comprises a non-releasing treatment region where a releasing treatment is not performed in one region of a substrate; and the protruding portion is adhered on the non-releasing treatment region.

Preferably, the pattern forming step is performed by irradiating the resin composition with a curing light in a condition where the transfer pattern of the pattern adding mold is pressed against the resin composition to cure the resin composition, followed by removal of the pattern adding mold from the resin composition to form the additional pattern on the resin composition.

Preferably, the film mold comprises the resin layer on a resin substrate, and an exposed region with no resin layer is provided at an end portion of the film mod in a winding direction.

### BREIF DESCRIPTION OF THE DRAWINGS

FIG. 1 is a cross sectional view of a film mold according to the first embodiment of the present invention.
FIG. 2 is a cross sectional view showing the film mold of FIG. 1 having a double-sided adhesive tape adhered thereon.
FIG. 3 is a cross sectional view showing a step in which the film mold with the double-sided adhesive tape of FIG. 2 is being wound onto the transfer roll.
FIG. 4 is a cross sectional view showing the step following the step of FIG. 3, in which the film mold is wound onto the transfer roll.
FIG. 5 is an enlarged view of region A in FIG. 4.
FIG. 6 is a view following FIG. 5, in which a clearance at a portion where the both ends of the film mold are butted is filled with a resin composition.
FIG. 7 is a view following FIG. 6, showing a step in which an additional pattern is formed on the resin composition.
FIG. 8 is a view following FIG. 7, showing a condition after the additional pattern is formed on the resin composition.
FIG. 9 is a cross sectional view of a film mold according to the second embodiment of the present invention.
FIG. 10 is view corresponding to FIG. 5, in a case where the film mold of FIG. 9 is used.
FIG. 11 is a view following FIG. 10, in which a clearance at a portion where the both ends of the film mold are butted is filled with a resin composition.
FIG. 12 is a view following FIG. 11, showing a step in which an additional pattern is formed on the resin composition.
FIG. 13 is a view following FIG. 12, showing a condition after the additional pattern is formed on the resin composition.
FIG. 14 is a view corresponding to FIG. 5, in a case where a film mold according to the third embodiment of the present invention is used.
FIG. 15 is a view following FIG. 14, in which the clearance at a portion where the both ends of the film mold are butted is filled with a resin composition.
FIG. 16 is a view following FIG. 15, showing a step in which an additional pattern is formed on the resin composition.
FIG. 17 is a view following FIG. 16, showing a condition after the additional pattern is formed on the resin composition.
FIG. 18 is a cross sectional view of the fourth embodiment of the present invention, in which a double-sided adhesive tape and the film mold are adhered so that the position of the double-sided adhesive tape and the film mold are matched at the end portion in the winding direction.
FIG. 19 is a view corresponding to FIG. 5, showing a condition where the double-sided adhesive tape and the film mold of FIG. 18 are wound onto the transfer roll.
FIG. 20 is a view showing a condition after an additional pattern is formed onto a resin composition filled in a clearance G according to the fourth embodiment of the present invention.

### DESCRIPTION OF EMBODIMENTS

Hereinafter, the preferred embodiments of the present invention will be described specifically with reference to the drawings.

### 1. First Embodiment

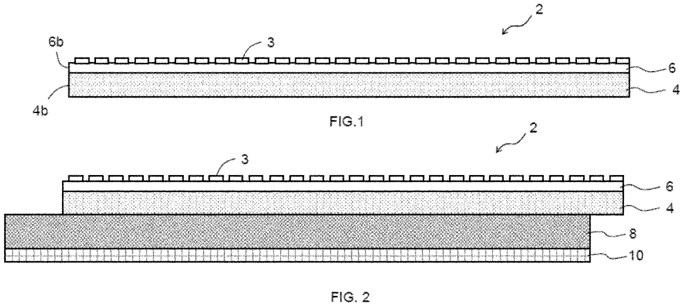

The method for manufacturing the imprint mold according to the first embodiment of the present invention will be described with reference to FIGs. 1 to 8. The method for manufacturing the imprint mold according to the present embodiment comprises a winding step, a resin filling step, and a pattern forming step.

Hereinafter, each of the steps will be described in detail.

### 1-1. Winding Step

In this step, as shown in FIGs. 1 to 5, the film mold 2 having a resin layer 6, the resin layer having a base pattern 3 which is a reverse pattern of the desired fine concave-convex pattern is wound onto the cylinder transfer roll 12 so as to form a clearance G at the butting portion of both ends, the clearance G having no base pattern 3.

### (1) Film Mold 2

Film mold 2 can be formed using a conventional imprint technology. In one example, as shown in FIG. 1, the film mold 2 comprises a flexible resin substrate 4, and a resin layer 6 provided on the resin substrate 4, the resin layer 6 having a base pattern 3.

Specifically, the resin substrate 4 is made of one type of a resin selected from the group consisting of polyethylene terephthalate, polycarbonate, polyester, polyolefin, polyimide, polysulfone, polyether sulfone, cyclic polyolefin, and polyethylene naphthalate.

On the other hand, as the resin for forming the resin layer 6, a thermoplastic resin, a thermosetting resin, and a photo-curing resin can be mentioned. As the resin, an acryl-based resin, a styrene-based resin, an olefin-based resin, a polycarbonate resin, a polyester-based resin, an epoxy resin, a silicon-based resin, and a mixture thereof can be mentioned.

The thickness of the resin layer 6 is usually 50 nm to 1 mm, preferably 500 nm to 500 µm. When the thickness of the resin layer 6 is in such range, imprint process can be performed without difficulty.

When the resin forming the resin layer 6 is a thermoplastic resin, a mold for forming the base pattern is pressed against the resin layer 6 with a pressing pressure of 0.5 to 50 MPa for 10 to 600 seconds while the resin layer 6 is kept under heating at a temperature higher than the glass transition temperature (Tg). Subsequently, the resin layer 6 is cooled to a temperature below Tg, followed by separation of the mold from the resin layer 6. Accordingly, the base pattern 3 is formed on the resin layer 6. On the other hand, when the resin forming the resin layer 6 is a photo-curing resin, the mold for forming the base pattern is pressed against the resin layer 6 in the form of a liquid, and then the resin layer 6 is irradiated with curing light (general term for energy ray capable of curing the resin such as UV light, visible light, electron beam and the like) to cure the resin layer 6. Subsequently, the mold is separated from the resin layer 6 to give the resin layer 6 having the base pattern 3. The resin layer 6 can be irradiated with the light from the resin substrate 4 side, or from the mold side when the mold is transparent with respect to the light. When the resin forming the resin layer 6 is a thermosetting resin, the resin layer 6 is heated up to the curing temperature in a condition where the mold for forming the base pattern is pressed against the resin layer 6 in the form of a liquid, thereby curing the resin layer 6. Subsequently, the mold is separated from the resin layer 6 to give the resin layer 6 having the base pattern 3.

There is no particular limitation regarding the pattern of the base pattern 3. Here, a pattern having an interval of 10 nm to 2 mm and a depth of 10 nm to 500 µm is preferable, and a pattern having an interval of 20 nm to 20 µm and a depth of 50 nm to 1 µm is more preferable. As the surface pattern, moth-eye, line, cylinder, monolith, cone, polygonal pyramid, and microlens can be mentioned.

The resin layer 6 can be subjected to a releasing treatment. As the releasing treatment, a releasing layer can be formed on the surface of the resin layer 6, or the resin layer 6 can be formed with a releasing resin (a resin containing a releasing component).

The releasing agent for forming the releasing layer (not shown) preferably comprises at least one type selected from the group consisting of a fluorosilane coupling agent, a perfluoro compound having an amino group or a carboxyl group, a perfluoroether compound having an amino group or a carboxyl group, a fluorine-based surfactant, and a silicone-based surfactant. More preferably, the releasing agent comprises at least one type selected from the group consisting of a fluorosilane coupling agent, a one-end-aminated perfluoro(perfluoroether) compound, and a one-end-carboxylated perfluoro(perfluoroether) compound, either as a single compound or a mixture of single compound and multiple compounds. When the releasing agent as described above is used, the adhesion property of the releasing layer formed by the releasing agent with the resin layer 6 would be excellent, and the releasing property of the releasing layer formed by the releasing agent from the resin for imprint would be excellent. The thickness of the releasing layer (not shown) is preferably 0.5 to 20 nm, more preferably 0.5 to 10 nm, and most preferably 0.5 to 5 nm. Here, in order to improve the adhesion between the releasing layer and the resin layer 6, the resin layer 6 can be added with an additive having a functional group capable of bonding with the releasing agent, as disclosed in WO 2012/018045.

In addition, regarding the releasing resin forming the resin layer 6, a silicone resin such as polydimethylsiloxane (PDMS), copolymer of acryl-based monomer and silicone-based monomer, copolymer of acryl-based monomer and fluorine-based monomer, mixture of acryl-based polymer and silicone-based monomer, or a mixture of acryl-based polymer and fluorine-based monomer can be used. In such case, the step of forming the releasing layer on the surface of the resin layer after forming the resin layer 6 can be omitted, and thus it is preferable.

The length of the film mold 2 is preferably slightly shorter than the outer circumference length of the transfer roll 12 onto which the film mold 2 is wound. In such case, a clearance G will be formed at the butting portion of both ends of the film mold 2 when the film mold 2 is would onto the transfer roll 12.

### (2) Double-sided Adhesive Tape

The film mold 2 cannot be adhered onto the transfer roll 12 as it is, and thus it is necessary to wind the film mold 2 onto the transfer roll 12 after coating an adhesive agent onto the surface of the film mold 2 to be attached with the transfer roll 12, or to adhere a double-sided adhesive tape 8 onto the surface of the film mold 2 to be attached with the transfer roll 12 and then wind the film mold 2 onto the transfer roll 12 through the medium of the double-sided adhesive tape 8 (as shown in FIG. 2). Since the latter procedure is preferable in terms of workability, explanation is given for the double-sided adhesive tape 8 suitably used in the present embodiment. Here, the surface of the double-sided adhesive tape 8 to be adhered onto the roll is provided with a separator 10 for protecting the adhesive layer of the double-sided adhesive tape 8.

There is no particular limitation regarding the structure of the double-sided adhesive tape 8, so long as the film mold 2 can be adhered onto the transfer roll 12. In a typical case, a polyethylene terephthalate film (not shown) is used as a core material, and it is preferable that the adhesion strength at the surface to be adhered onto the film mold 2 (hereinafter referred to as "mold adhering surface") is higher than the adhesion strength at the surface to be adhered onto the transfer roll 12 (hereinafter referred to as "roll adhering surface"). In addition, it is preferable that the roll adhering surface is re-releasable. After adhering the film mold 2 onto the transfer roll 12 through the medium of the double-sided adhesive tape 8, the double-sided adhesive tape 8 and the film mold 2 are removed together and disposed. Accordingly, it is preferable that the adhesion strength of the mold adhering surface of the double-sided adhesive tape 8 is as high as possible, in order to prevent displacement of the double-sided adhesive tape 8 and the film mold 2. On the other hand, the adhesion strength of the roll adhering surface of the double-sided adhesive tape 8 is preferably in the range so as to allow easy removal from the transfer roll 12 after usage, that is, strong enough to assure usage while being re-releasable. The thickness of the film as the core material is preferably in the range of 12 to 100 µm. When the thickness is less than 12 µm, the workability during the adhesion of the film mold 2 onto the transfer roll 12 would decrease. On the other hand, when the thickness exceeds 100 µm, the elasticity of the film increases and the film mold 2 would tend to rise apart from the transfer roll 12, and thus it is unfavorable. There is no particular limitation regarding the adhesive agent layer so long as the afore-mentioned releasing properties are satisfied. Here, the adhesive agent layer is preferably structured with an acryl-based adhesive agent composition or a silicone-based adhesive agent composition in terms of cost, workability, and physical property. There is no particular limitation regarding the acryl-based adhesive agent composition. For example, the ones having an additive such as a crosslinker formulated into the acryl-based polymer can be mentioned. The thickness of the adhesive agent layer is generally in the range of 5 to 50 µm regarding both of the mold adhering surface and the roll adhering surface. When the thickness is in such range, the adhesive agent can function as a buffer material, and is thus preferable since it can improve the transferring accuracy.

The end portion of the double-sided adhesive tape 8 and the film mold 2 in the direction of winding can be aligned, but is preferably shifted. In such case, the position of the butting portion of both ends of the double-sided adhesive tape 8 and the butting portion of both ends of the film mold 2 can be shifted when the film mold 2 is wound onto the transfer roll 12 through the medium of the double-sided adhesive tape 8. Accordingly, the resin composition 22 filled into the butting portion of both ends of the film mold 2 can be filled into the portion other than the butting portion of the double-sided adhesive tape 8, thereby preventing the resin composition 22 from adhering to the transfer roll 12.

The length of the double-sided adhesive tape 8 is preferably substantially the same as the outer circumference length of the transfer roll 12. In such case, the double-sided adhesive tape 8 can be adhered onto the entire circumference of the transfer roll 12 without any clearance. Accordingly, when the length of the film mold 2 is slightly shorter than the outer circumference length of the transfer roll 12, the double-sided adhesive tape 8 would be slightly longer than the film mold 2.

There is no particular limitation regarding the structure of the separator 10, so long as it can protect the adhesive agent layer at the roll adhering surface of the double-sided adhesive tape 8, and can be easily removed when winding the film mold 2 onto the transfer roll 12.

### (3) Winding of Film Mold 2 Onto Transfer Roll 12

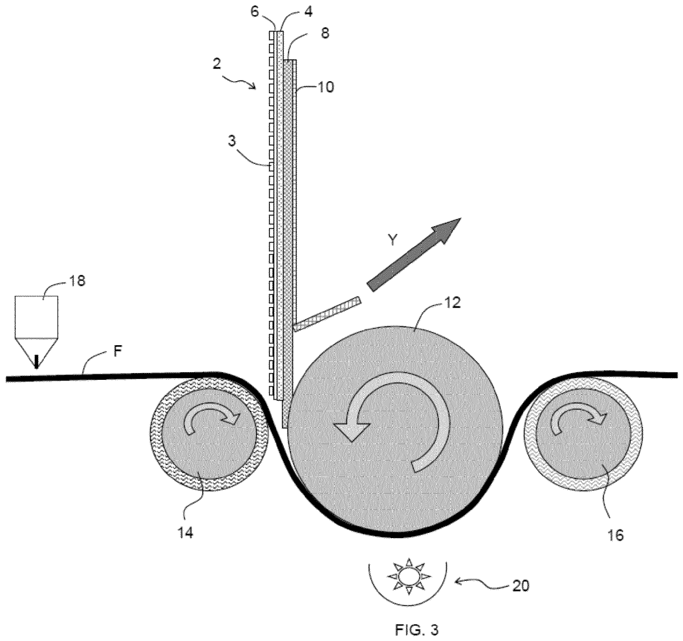

Next, the method for winding the film mold 2 onto the transfer roll 12 will be described in detail. Here, a case where an apparatus as shown in FIG. 3 is used will be explained as an example. However, the structure of the apparatus is not limited to such, and the method for winding is also not limited to the one described herein.

FIG. 3 shows an imprint apparatus for imprinting a concave-convex pattern onto a transferring material. The film mold 2 is wound onto the transfer roll 12, usually in a condition where the transfer roll 12 is installed in the imprint apparatus. The apparatus comprises a transfer roll 12 to wind the film mold 2 thereon; an upper stream roll 14 to insert the film mold 2 in between the transfer roll 12 and a conveying film F, the upper stream roll 14 being arranged at the upper stream side of the transfer roll 12; and a lower stream roll 16 arranged at the lower stream side of the transfer roll 12. A forwarding roll (not shown) to forward the conveying film F is further arranged at the upper stream side of the upper stream roll 14, and a winding roll (not shown) to wind the conveying film F is further arranged at the lower stream side of the lower stream roll 16. In addition, a coater 18 (a die coater for example) to coat the transferring material (photo-curing resin for example) onto the conveying film is arranged in between the forwarding roll and the upper stream roll 14, and a light irradiator 20 (UV light for example) to cure the transferring material is arranged at the lower stream side of the transfer roll 12. When the film mold 2 is being wound, the coater and the light irradiator are not used.

First, as shown in FIG. 3, the film mold 2 having the double-sided adhesive tape 8 with the separator 10 adhered thereon is arranged at the tangential line of the transfer roll 12, and then the film mold 2 with the double-sided adhesive tape 8 is inserted in between the conveying film F and the transfer roll 12 while peeling off the separator 10 in the direction shown by the arrow Y. In this state, each of the rolls is rotated in the direction as indicated by each of the arrows. The film mold 2 with the double-sided adhesive tape 8 is pressed against the transfer roll 12 by the upper stream roll 14, thereby adhering the roll adhering surface of the double-sided adhesive tape 8 onto the transfer roll 12.

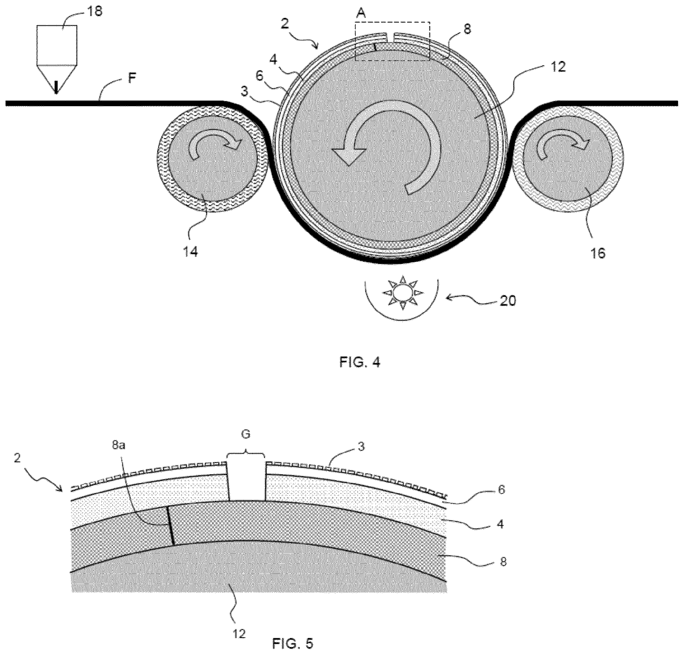

By allowing each of the rolls to rotate in such condition, the film mold 2 with the double-sided adhesive tape 8 becomes entirely wound onto the transfer roll 12, thereby achieving the structure as shown in FIG. 4 and FIG. 5. FIG. 5 is an enlarged view of region A in FIG. 4.

As shown in FIG. 5, the double-sided adhesive tape 8 is adhered onto the entire circumference of the transfer roll 12, and there is substantially no clearance at the butting portion 8a of both ends. Here, a narrow clearance would cause no problem. At the butting portion of the both ends of the film mold 2, a clearance G is provided. The length of the clearance G (here, the length in the circumference direction of the roll is referred to as "length", and the length in the direction of the rotation axis of the roll is referred to as "width") is not particularly limited. For example, the length is 0.1 to 10 mm, preferably 0.5 to 5 mm.

### 1-2. Resin Filling Step

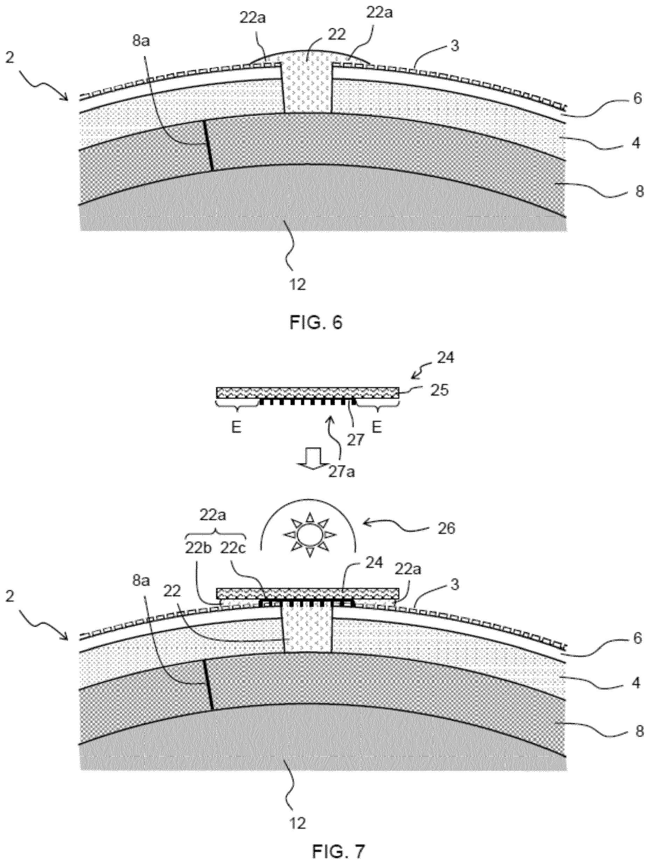

In this step, as shown in FIG. 6, the resin composition 22 is filled in the clearance G. There is no particular limitation regarding the method for filling the resin composition 22. For example, the resin composition can be filled using a micropipette.

As shown in FIG. 6, the resin composition 22 is filled so as to protrude from the clearance G and to form a protruding portion 22a of the resin composition 22 on the surface of the resin layer 6. By filling the resin composition in such manner, occurrence of level difference between the base pattern 3 formed on the film mold 2 and the additional pattern 3a formed on the resin composition 22 in the clearance G can be suppressed even when the width of the clearance became larger than the specified value due to dimensional error. Here, it is preferable that the resin composition 22 is filled so that the protruding portion 22a is already formed before the pattern adding mold 24 is pressed in the pattern forming step. However, the resin composition 22 can be filled so that the protruding portion 22a is not formed at the time when the resin composition 22 is filled in the clearance G, and the protruding portion 22a is formed when the pattern adding mold 24 is pressed against the resin composition 22.

The resin composition 22 is a thermosetting resin or a photo-curing resin. As the resin, an acrylic resin, an epoxy resin, and a silicone resin can be mentioned. When the resin is a thermosetting resin or a photo-curing resin, the resin can be easily cured after forming the pattern, and thus it can be handled easily.

The resin composition 22 is preferably a releasing resin. When the releasing resin is used, adhesion of the transferring material can be prevented while imprinting of the concave-convex pattern onto the transferring material is conducted without forming the releasing layer after forming the additional pattern 3a onto the resin composition 22. As the releasing resin, a mixture of the afore-mentioned thermosetting resin or the photo-curing resin with the releasing agent, a silicone resin such as polydimethyl siloxane (PDMS), a copolymer of acryl-based monomer and silicone-based monomer (including macromonomer), and a copolymer of acryl-based monomer and fluorine-based monomer (including macromonomer) can be mentioned for example. Here, the mixture of the thermosetting resin or the photo-curing resin with the releasing agent, and the silicone resin are preferable. Such resins are available at low cost, and can exhibit its releasing property sufficiently with respect to the transferring material, onto which a pattern is transferred by the roll to roll method. Here, when the resin is the photo-curing resin or the thermosetting resin, the resin can be handled easily since the resin can be cured easily after forming the pattern. As the releasing agent, a silicone compound, a fluorine compound, an alkyd resin, a long-chain alkyl compound, and wax can be mentioned for example.

### 1-3. Pattern Forming Step

In this step, a transfer pattern 27a provided on a pattern adding mold 24 is pressed against the resin composition 22, thereby forming an additional pattern 3a comprising a reverse pattern of the transfer pattern 27a on the resin composition 22. The additional pattern 3a is preferably substantially the same as the base pattern 3, however, it can be a different pattern.

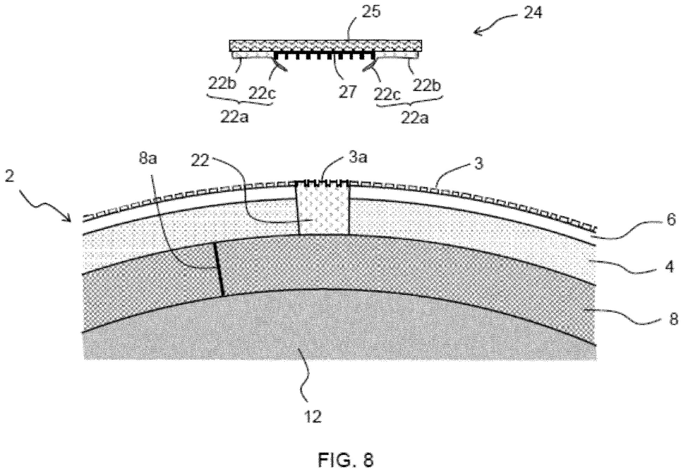

Specifically, as shown in FIG. 7, when the resin composition 22 is a photo-curing resin, the resin composition 22 is irradiated with a curing light using a light irradiator 26 in a condition where the transfer pattern 27a of the pattern adding mold 24 is pressed against the resin composition 22. After the resin composition 22 is cured, the pattern adding mold 24 is removed from the resin composition 22, thereby forming the additional pattern 3a on the resin composition 22 as shown in FIG. 8. The protruding portion 22a of the resin composition 22 may not be irradiated with the curing light.

The pattern adding mold 24 is preferably transparent with respect to the curing light for curing the resin composition 22. In such case, the resin composition 22 can be irradiated with the curing light through the pattern adding mold 24. The pattern adding mold 24 comprises a substrate 25 comprising a material such as resin and quartz, and a resin layer 27 provided in a partial region on the substrate 25. The transfer pattern 27a is formed on the resin layer 27. The resin layer 27 can be formed with a material similar as the resin layer 6 of the film mold 2, and can be subjected to the releasing treatment as necessary. The transfer pattern 27a is preferably formed with an area larger than the opening of the clearance G. Since the substrate 25 is not subjected to the releasing treatment, the region on the substrate 25 which is not provided with the resin layer 27 is the non-releasing treatment region E.

As shown in FIG. 8, the protruding portion 22a is preferably removed from the surface of the resin layer 6 by adhering the protruding portion 22a onto the pattern adding mold 24 when the pattern adding mold 24 is removed from the resin composition 22. It is preferable that the protruding portion 22a is adhered onto the non-releasing treatment region E provided on the substrate 25. As shown in FIGs. 7 to 8, the protruding portion 22a is structured with a protruding portion 22b between the substrate 25 and the resin layer 6 and a protruding portion 22c between the resin layer 27 and the resin layer 6.

Here, preferable relationship of the releasing force between the resin composition 22 and another member will be described. In the following description, F1 through F4 are defined as shown in Table 1. Here, the releasing force is a force required to release the resin composition 22 from another member.

**[Table 1]**

| | |
|---|---|
| F1 | releasing force between resin composition 22 and substrate 25 of pattern adding mold 24 |
| F2 | releasing force between resin composition 22 and resin layer 6 of film mold 2 |
| F3 | releasing force between resin composition 22 and base of clearance G of film mold 2 |
| F4 | releasing force between resin composition 22 and resin layer 27 of pattern adding mold 24 |

In order to remove the protruding portion 22a by the afore-mentioned method, it is preferable to satisfy the relationship of F1 > F2. In such case, when the non-releasing treatment region E of the substrate 25 is pressed against the resin composition 22, the resin composition 22 would be adhered on both of the substrate 25 and the resin layer 6. When the pattern adding mold 24 is removed from the resin composition 22 in such conditions, the resin composition 22 would be released from the resin layer 6 and would be adhered on the non-releasing treatment region E of the substrate 25, thereby removing the protruding portion 22b from the surface of the resin layer 6. The relationship of F1 > F2 can be satisfied by not performing the releasing treatment to the non-releasing treatment region E of the substrate 25 and performing the releasing treatment to the resin layer 6. Here, since the protruding portion 22b is connected to the protruding portion 22c, the protruding portion 22c can be removed from the surface of the resin layer 6 with the protruding portion 22b.

In order to avoid the resin composition 22 in the clearance G from being adhered onto the resin layer 27 of the pattern adding mold 24 and be removed when the resin composition 22 is removed from the pattern adding mold 24, it is preferable to satisfy the relationship of F3 > F4. The relationship of F3 > F4 can be satisfied by not performing the releasing treatment to the base of the clearance G, and performing the releasing treatment to the resin layer 27.

Taking the afore-mentioned circumstances into consideration, the relationship of the releasing force preferably satisfies F3 > F1 > F4, F2. The relationship between F4 and F2 can be either one of F4 > F2, F4 ≈ F2, and F2 < F4.

Here, instead of removing the protruding portion 22a by adhering the protruding portion 22a on the pattern adding mold 24, a step to remove the protruding portion 22a can be conducted separately after removing the pattern adding mold 24 from the resin composition 22.

The pattern surface of the pattern adding mold 24 (the surface at the side of transfer roll 12) preferably has a curvature substantially the same as the transfer roll 12. In such case, the additional pattern 3a formed can be shaped so as to more fit with the outer circumference of the transfer roll 12. In addition, the pattern adding mold 24 is preferably a mold having flexibility as the film mold. In such case, the resin composition 22 can be cured in a condition where the pattern adding mold 24 is deformed so as to follow the shape of the outer circumference of the transfer roll 12, in order to form the additional pattern 3a having a shape which further fits with the outer circumference of the transfer roll 12.

In accordance with the afore-mentioned process, an imprint mold with a continuous pattern provided over the entire circumference of the transfer roll 12 with suppressed occurrence of level difference can be obtained.

By using such imprint mold, a concave-convex pattern can be continuously formed onto the transferring material. In a specific example, each of the rolls of the imprint apparatus shown in FIG. 4 is rotated so as to convey the conveying film F while ejecting the transferring material (photo-curing resin for example) from the coater 18, thereby coating the transferring material onto the conveying film F. The seamless imprint mold wound onto the transfer roll 12 is pressed against the transferring material, and the transferring material is irradiated with light provided from the light irradiator 20 in order to cure the transferring material in such condition. Accordingly, a concave-convex pattern can be formed continuously onto the transferring material. Since occurrence of level difference between the base pattern 3 and the additional pattern 3a is suppressed with the imprint mold manufactured with the afore-mentioned method, transfer defectiveness due to the level difference can be suppressed.

### 2. Second Embodiment

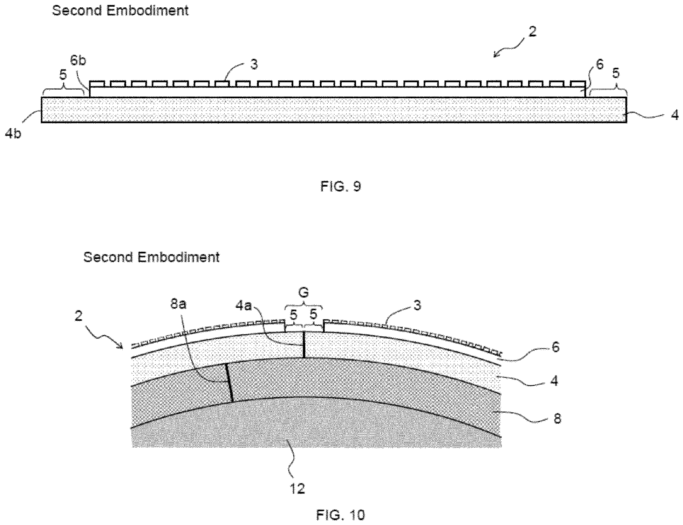

The second embodiment of the present invention is similar with the first embodiment. As shown in FIG. 9, the second embodiment differs from the first embodiment in the point that an exposed region 5 having no resin layer 6 is provided in the film mold 2, the exposed region 5 being positioned at the end of the film mold 2 with respect to the winding direction.

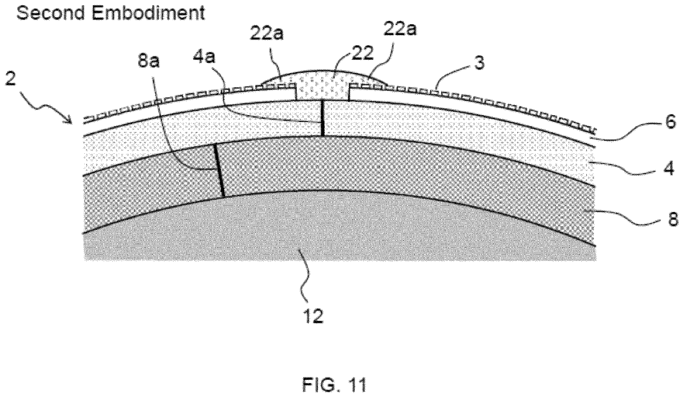

Regarding the film mold 2 having such constitution, the length of the film mold 2 (that is, the length of the resin substrate 4) can be nearly the same as the outer circumference of the transfer roll 12 onto which the film mold 2 is wound. In such case, there would be substantially no clearance at the butting portion 4a of the both ends of the resin substrate 4 when the film mold 2 is wound onto the transfer roll 12 (as shown in FIG. 10). Accordingly, when the resin composition 22 is filled into the clearance G in such condition, the resin composition 22 would be filled onto the resin substrate 4 as shown in FIG. 11. In a similar manner as in the first embodiment, the resin composition 22 is filled so as to protrude from the clearance G to form a protruding portion 22a of the resin composition on the surface of the resin layer 6.

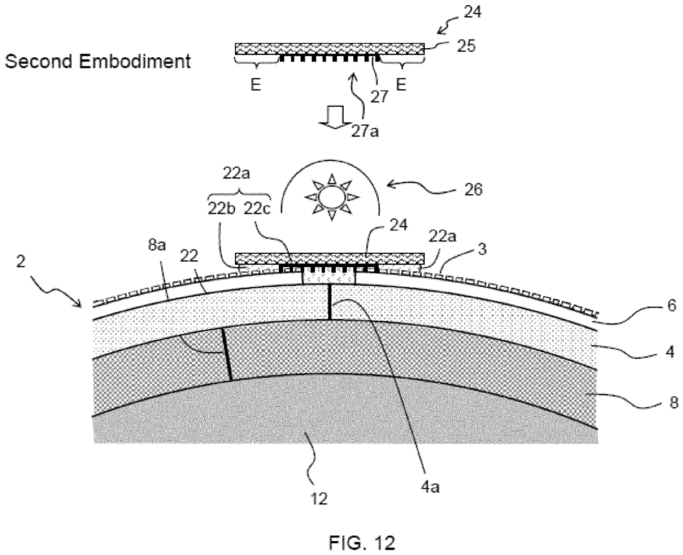

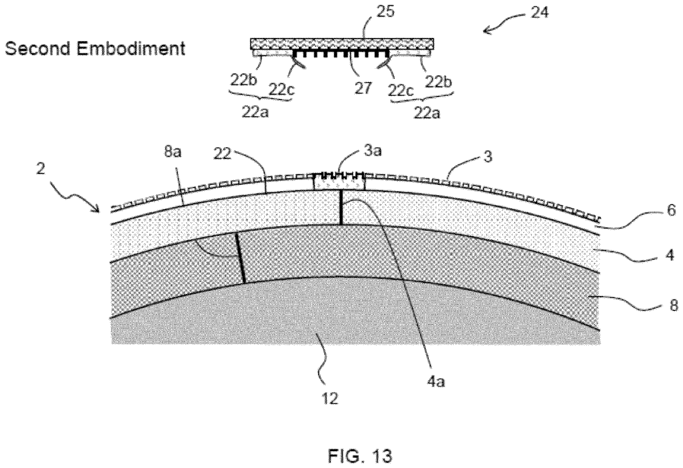

Subsequently, as shown in FIG. 12, when the additional pattern 3a is formed on the resin composition 22 with a method similar as that of the first embodiment, a constitution as shown in FIG. 13 is obtained. The protruding portion 22a can be removed by a similar step as that of the first embodiment. Here, while the base of the clearance G was the double-sided adhesive tape 8 in the first embodiment, the base of the clearance G in the second embodiment is the resin substrate 4.

In accordance with the afore-mentioned process, an imprint mold with a continuous pattern provided over the entire circumference of the transfer roll 12 with suppressed occurrence of level difference can be obtained.

As apparent from the comparison between FIG. 6 and FIG. 11, since the resin composition 22 is filled onto the resin substrate 4 in the second embodiment, the amount of the resin composition 22 can be suppressed compared with the amount of the resin composition 22 filled onto the double-sided adhesive tape 8 as shown in FIG. 6. Therefore, manufacturing efficiency can be improved.

In addition, in the first embodiment, as shown in FIG. 1, since the position of the end face 4b of the resin substrate 4 and the position of the end surface 6b of the resin layer 6 are aligned, the resin composition 22 would be filled in the clearance G adjacent to the end surface 4b but does not cover the end surface 4b completely. Accordingly, when the cut end of the film mold 2 is not smooth, a level difference easily occur at the position corresponding to the end surface 4b of the resin substrate 4. On the other hand, in the second embodiment, as shown in FIG. 9, the resin substrate 4 is longer than the resin layer 6 in the winding direction of the film mold 2. Accordingly, the position of the end surface 4b of the resin substrate 4 and the position of the end surface 6b of the resin layer 6 are not aligned. Therefore, when the resin composition 22 is filled into the clearance G, the end surface 4b is covered completely with the resin composition 22. With such constitution, even in a case where the cut end of the film mold 2 is not smooth, a level difference hardly occur at the position corresponding to the end surface 4b of the resin substrate 4. That is, occurrence of level difference between the base pattern 3 and the additional pattern 3a can be further suppressed.

### 3. Third Embodiment

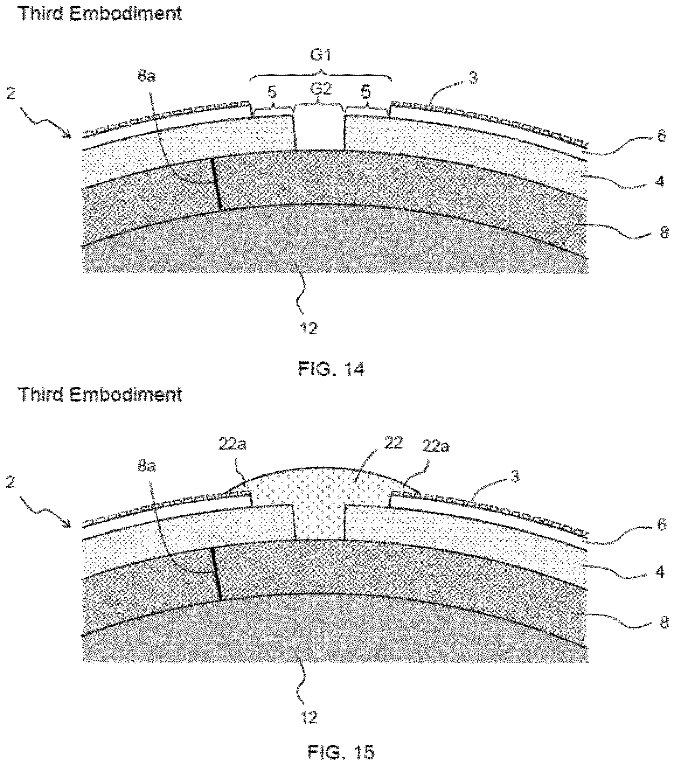

The third embodiment of the present invention is similar with the second embodiment. As shown in FIG. 14, in the third embodiment, clearance G1 is provided at the butting portion of the resin layer 6 in the winding direction, and clearance G2 is provided at the butting portion of the resin substrate 4 in the winding direction. Here, clearance G1 is larger than clearance G2.

As shown in FIG. 15, clearances G1 and G2 can be filled with the resin composition 22 in a similar manner as the second embodiment. In a similar manner as the second embodiment, the resin composition 22 is filled so as to protrude from clearances G1 and G2 to form a protruding portion 22a of the resin composition on the surface of the resin layer 6.

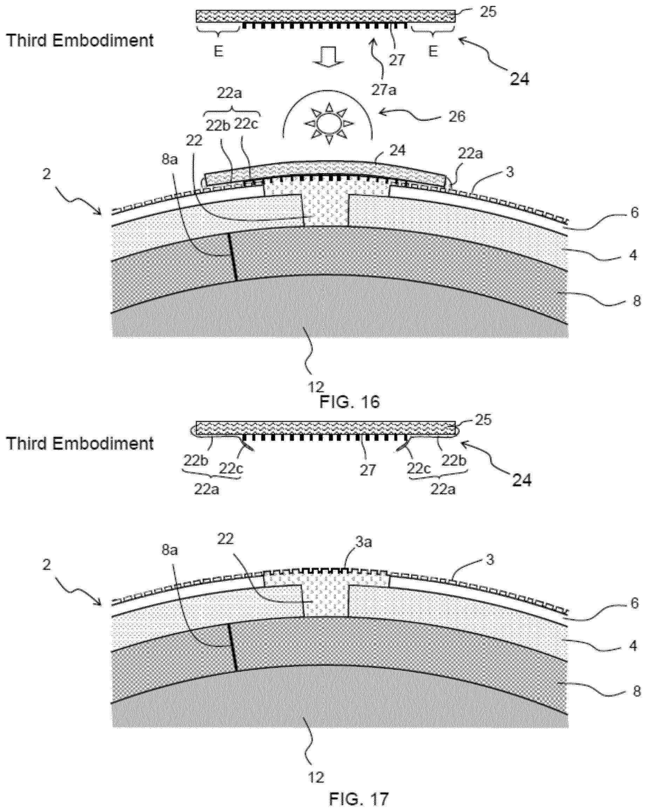

Subsequently, as shown in FIG. 16, when the additional pattern 3a is formed on the resin composition 22 with a method similar as that of the second embodiment, a constitution as shown in FIG. 17 is obtained. The protruding portion 22a can be removed in a similar manner as the second embodiment. Here, while the base of the clearance G was the resin substrate 4 in the second embodiment, the base of the clearance G2 in the third embodiment is the double-sided adhesive tape 8, and the base of the clearance G1 other than the portion of the clearance G2 is the resin substrate 4.

In the second embodiment, accuracy of the cutting size of the film mold 2 need be extremely high in order to make the butting portion of both ends 4a of the resin substrate 4 be substantially free of clearance. However, the third embodiment merely requires to set the cutting size of the film mold 2 to be a little shorter than the outer circumference of the transfer roll 12, and thus accuracy of the cutting size of the film mold 2 may be low. In addition, since the resin composition 22 is provided on the resin substrate 4 in the second embodiment, when a circumferential force is applied to the resin composition 22 in the clearance G, the resin composition 22 is easily removed from the resin substrate 4. On the other hand, in the third embodiment, since the resin composition 22 is filled also in the clearance G2 at the butting portion of the resin substrate 4, the resin composition 22 is hardly removed from the resin substrate 4 even when a circumferential force is applied to the resin composition in the clearances G1 and G2. Therefore, according to the third embodiment, when imprint is performed using the seamless imprint mold obtained by winding the film mold 2 onto the transfer roll 12, removal of the resin composition 22 can be suppressed even when a circumferential force is applied to the resin composition 22.

### 4. Fourth Embodiment

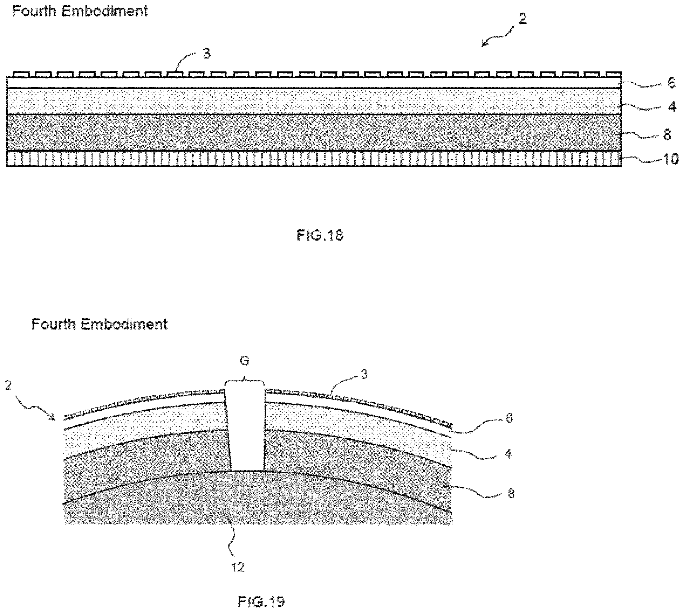

The fourth embodiment of the present invention is similar with the first embodiment. Here, as shown in FIG. 18, the position of the end portion of the double-sided adhesive tape 8 and the film mold 2 are aligned with respect to the winding direction in the fourth embodiment.

The length of the double-sided adhesive tape 8 and the film mold 2 are slightly shorter than the outer circumference of the transfer roll 12. Accordingly, as shown in FIG. 19, when the double-sided adhesive tape 8 and the film mold 2 are wound onto the transfer roll 12, clearance G is formed at the butting portion of both ends of the film mold 2 and at the butting portion of both ends of the double-sided adhesive tape 8.

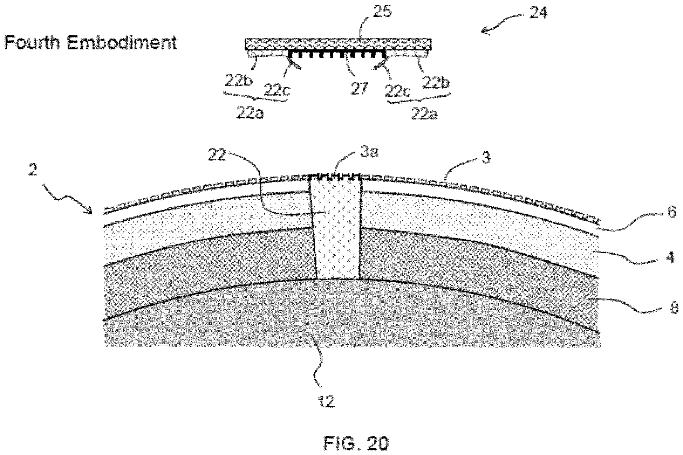

In a similar manner as the first embodiment, resin composition 22 is filled in the clearance G followed by formation of additional pattern 3a. Accordingly, a constitution as shown in FIG. 20 is obtained.

Regarding the afore-mentioned second embodiment and the third embodiment, the position of the end portion of the double-sided adhesive tape 8 and the film mold 2 can be aligned with respect to the winding direction.

### EXPLANATION OF SYMBOLS

2: film mold, 3: base pattern, 3a: additional pattern, 4: resin substrate, 4a: butting portion of both ends of resin substrate, 6: resin layer, 8: double-sided adhesive tape, 8a: butting portion of both ends of double-sided adhesive tape, 10: separator, 12: transfer roll, 14: upper stream roll, 16: lower stream roll, 18: coater, 20: light irradiator, 22: resin composition, 22a: protruding portion, 24: pattern adding mold, 25: substrate, 27: resin layer, F: conveying film, G, G1, G2: clearance

## Claims

1. A method for manufacturing an imprint mold, comprising:
a winding step to wind a film mold (2) onto a cylinder transfer roll (12), the film mold (2) having a resin layer (6), the resin layer (6) having a base pattern (3) comprising a reverse pattern of a fine concave-convex pattern and the film mold (2) being wound so as to form a clearance (G) having no base pattern at a butting portion (8a) of both ends of the film mold (2);
a resin filling step to fill a resin composition (22) in the clearance (G); and
a pattern forming step to form an additional pattern (3a) comprising a reverse pattern of a transfer pattern (27a) on the resin composition (22) by pressing the transfer pattern (27a) provided on a pattern adding mold (24) against the resin composition (22); wherein
the resin composition (22) is filled so as to form a protruding portion (22a) of the resin composition (22) at a surface of the resin layer (6) by allowing the resin composition (22) to protrude from the clearance (G) before the pattern adding mold (24) is pressed against the resin composition (22) or when the pattern adding mold (24) is pressed against the resin composition (22),
**characterized in, that** the protruding portion (22a) is removed from the surface of the resin layer (6) by being adhered on the pattern adding mold (24) when the pattern adding mold (24) is removed from the resin composition (22).

2. The method of Claim 1, wherein:
the pattern adding mold (24) comprises a non-releasing treatment region (E) where a releasing treatment is not performed in one region of a substrate (25); and
the protruding portion (22a) is adhered on the non-releasing treatment region (E).

3. The method of any one of Claims 1 or 2, wherein:
the pattern forming step is performed by irradiating the resin composition (22) with a curing light in a condition where the transfer pattern (27a) of the pattern adding mold (24) is pressed against the resin composition (22) to cure the resin composition (22), followed by removal of the pattern adding mold (24) from the resin composition (22) to form the additional pattern (3a) on the resin composition (22).

4. The method of any one of Claims 1 to 3, wherein:
the film mold (2) comprises the resin layer (6) on a resin substrate (4), and an exposed region (5) with no resin layer (6) is provided at an end portion of the film mold (2) in a winding direction.

## Patentansprüche

1. Verfahren zur Herstellung einer Prägeform, umfassend:
einen Wickelschritt zum Wickeln einer flächigen Matrize (2) auf eine Zylindertransferrolle (12), wobei die flächige Matrize (2) eine Harzschicht (6) aufweist, wobei die Harzschicht (6) eine Grundstruktur (3) aufweist, die eine umgekehrte Struktur einer feinen konkav-konvexen Struktur umfasst, und die flächige Matrize (2) so gewickelt wird, dass an einem Aneinanderstoßabschnitt (8a) beider Enden der flächigen Matrize (2) ein Freiraum (G) ausgebildet wird, der keine Grundstruktur aufweist;
einen Harzeinfüllschritt zum Einfüllen einer Harzzusammensetzung (22) in den Freiraum (G); und
einen Strukturausbildungsschritt zum Ausbilden einer zusätzlichen Struktur (3a), die eine umgekehrte Struktur einer Transferstruktur (27a) umfasst, auf der Harzzusammensetzung (22), indem die Transferstruktur (27a), die auf einer Strukturhinzufügungsmatrize (24) vorgesehen ist, gegen die Harzzusammensetzung (22) gedrückt wird; wobei
die Harzzusammensetzung (22) so eingefüllt wird, dass an einer Oberfläche der Harzschicht (6) ein vorstehender Abschnitt (22a) aus der Harzzusammensetzung (22) ausgebildet wird, indem gestattet wird, dass die Harzzusammensetzung (22) aus dem Freiraum (G) vorsteht, bevor die Strukturhinzufügungsmatrize (24) gegen die Harzzusammensetzung (22) gedrückt wird oder wenn die Strukturhinzufügungsform (24) gegen die Harzzusammensetzung (22) gedrückt wird,
**dadurch gekennzeichnet, dass** der vorstehende Abschnitt (22a) von der Oberfläche der Harzschicht (6) entfernt wird, indem er an der Strukturhinzufügungsmatrize (24) haften bleibt, wenn die Strukturhinzufügungsmatrize (24) von der Harzzusammensetzung (22) entfernt wird.

2. Verfahren nach Anspruch 1, wobei:
die Strukturhinzufügungsmatrize (24) in einem Bereich eines Substrats (25) einen ablösebehandlungsfreien Bereich (E) umfasst, in dem keine Ablösebehandlung durchgeführt wird; und
der vorstehende Abschnitt (22a) an dem ablösebehandlungsfreien Bereich (E) haften bleibt.

3. Verfahren nach einem der Ansprüche 1 oder 2, wobei:
der Strukturausbildungsschritt durchgeführt wird, indem die Harzzusammensetzung (22) in einem Zustand, in dem die Transferstruktur (27a) der Strukturhinzufügungsmatrize (24) gegen die Harzzusammensetzung (22) gedrückt wird, mit einem Aushärtungslicht bestrahlt wird, um die Harzzusammensetzung (22) auszuhärten, gefolgt von der Entfernung der Strukturhinzufügungsmatrize (24) von der Harzzusammensetzung (22), um die zusätzliche Struktur (3a) auf der Harzzusammensetzung (22) auszubilden.

4. Verfahren nach einem der Ansprüche 1 bis 3, wobei:
die flächige Matrize (2) die Harzschicht (6) auf einem Harzsubstrat (4) umfasst und an einem Endabschnitt der flächigen Matrize (2) in einer Wickelrichtung ein freiliegender Bereich (5) ohne Harzschicht (6) vorgesehen ist.

## Revendications

1. Procédé de fabrication d'un moule d'empreinte, comprenant :
une étape d'enroulement où un moule de formation de film (2) est enroulé sur un rouleau de transfert cylindrique (12), le moule de formation de film (2) ayant une couche de résine (6), la couche de résine (6) ayant un motif de base (3) présentant un motif inverse d'un motif concave-convexe fin, et le moule de formation de film (2) étant enroulé de manière à former un espace (G) sans motif de base sur une zone de butée (8a) des deux extrémités du moule de formation de film (2) ;
une étape de comblement de résine où une composition de résine (22) est coulée dans l'espace (G) ; et
une étape de formation de motif où est formé un motif additionnel (3a) présentant un motif inverse d'un motif de transfert (27a) sur la composition de résine (22) par pression du motif de transfert (27a) prévu sur un moule d'ajout de motif (24) contre la composition de résine (22) ; où
la composition de résine (22) est coulée de manière à former une zone en saillie (22a) de la composition de résine (22) sur la surface de la couche de résine (6) en permettant à la composition de résine (22) de faire saillie depuis l'espace (G) avant pression du moule d'ajout de motif (24) contre la composition de résine (22) ou quand le moule d'ajout de motif (24) est pressé contre la composition de résine (22),
**caractérisé en ce que** la zone en saillie (22a) est retirée de la surface de la couche de résine (6) par adhérence sur le moule d'ajout de motif (24) quand le moule d'ajout de motif (24) est retiré de la composition de résine (22).

2. Procédé selon la revendication 1, où :
le moule d'ajout de motif (24) comprend une zone exempte de traitement de démoulage (E) où un traitement de démoulage n'est pas effectué dans une partie d'un substrat (25) ; et où
la zone en saillie (22a) adhère sur la zone exempte de traitement de démoulage (E).

3. Procédé selon la revendication 1 ou 2, où :
l'étape de formation de motif est exécutée par irradiation de la composition de résine (22) avec une lumière de durcissement dans un état où le motif de transfert (27a) du moule d'ajout de motif (24) est pressé contre la composition de résine (22) pour durcir la composition de résine (22), suivie du retrait du moule d'ajout de motif (24) de la composition de résine (22) pour former le motif additionnel (3a) sur la composition de résine (22).

4. Procédé selon l'une des revendications 1 à 3, où :
le moule de formation de film (2) comprend la couche de résine (6) sur un substrat en résine (4), et où une zone non exposée (5) exempte de couche de résine (6) est prévue sur une partie d'extrémité du moule de formation de film (2) dans la direction d'enroulement.
